# EUROPEAN PATENT APPLICATION

(11) **EP 3 778 057 A1**
(43) Date of publication of application: **17.02.2021**
(21) Application number: 19775909.5
(22) Date of filing: 25.02.2019
(51) Int. Cl.: B21D 22/20, B21D 22/00, B21D 22/26, B21D 24/00

(54) **RIGIDITY IMPROVEMENT METHOD FOR PRESS-MOLDED ARTICLE, PRESS-MOLDING DIE, PRESS-MOLDED ARTICLE, AND PRODUCTION METHOD FOR PRESS-MOLDED ARTICLE**

(30) Priority: 28.03.2018 JP 2018062817
(71) Applicant: JFE Steel Corporation, Tokyo 100-0011 (JP)
(72) Inventor: KARIYAZAKI, Yuta, Tokyo 100-0011 (JP); YAMASAKI, Yuji, Tokyo 100-0011 (JP)
(74) Representative: Grünecker Patent- und Rechtsanwälte PartG mbB
(86) International application number: PCT/JP2019/006935
(87) International publication number: WO 2019/187864

(57) **Abstract**

To suppress springback of the press-formed product, in improving rigidity of a press-formed product having a low rigidity shape produced by press-forming a sheet material by a rigidity adding shape to suppress springback at a time when the press-formed product is removed from a die, the rigidity adding shape is arranged to extend in a direction of crossing a displacement contour indicating a state of springback in an initial shape prior to an arrangement of the rigidity adding shape of the press-formed product.

## Description

### Technical Field

The present invention relates to a rigidity improvement method for a press-formed product, a press-forming die, a press-formed product, and a method for producing a press-formed product for suppressing springback at the time when the press-formed product produced by press-forming a sheet material is removed from the press-forming die.

### Background Art

In recent years, high-strength steel sheets have been more widely used in order to reduce the weight of automobile bodies for improved fuel efficiency. With the use of a high strength steel sheet, the strength, rigidity and the energy absorbed in a collision of an automobile body can be increased without increasing the sheet thickness.

However, in press-forming which is widely used for processing of body parts of automobiles, failure in shape freezing called springback becomes a problem. The springback occurs when a press-formed product produced by press-forming a steel sheet, which is a sheet material, is removed from a press-forming die and becomes larger when the material strength of the steel sheet increases. The shape defect due to the springback not only impairs the external appearance quality, but also causes failure in welding at the time of assembly of an automobile body. Therefore, the expansion of the use of the high strength steel sheet requires springback measures.

The springback is caused by elastic recovery generated when a bending moment due to a non-uniform residual stress is released at the removal of a press-formed product from a die. Therefore, there has been proposed a method for mitigating the non-uniform residual stress and a method for reducing the springback by improving the rigidity of the press-formed product as a countermeasure for springback.

For example, Patent Literature 1 proposes a method that an emboss is arranged on a stretch flange portion and an excess bead is formed on a shrink flange portion to form an intermediate formed product, and, in the subsequent forming of a final formed product, the emboss is crushed to give the stretch flange portion a compression stress and a tensile stress is applied to the shrink flange portion by the excess bead, such that the residual stress distribution of the press-formed product is made uniform.

Patent Literature 2 proposes a press-forming method in which, in press-forming a flanged channel-shaped member using a high strength steel sheet, a flange portion is provided with a bead, so that tension applied to a vertical wall portion during press formation is increased to improve the dimension accuracy.

Patent Literature 3 proposes a technique of preventing generation of warpage by providing a bead at a bottom portion of a square-shaped drawn container along a fillet portion of the long side.

Patent Literature 4 proposes a technique of suppressing warpage due to a bending moment by providing radial beads on non-pierced portions located between pierced portions that are circumferentially adjacent to each other in a damper plate material that constitutes an automotive clutch or the like.

### Citation List

### Patent Literature

Patent Literature 1: JP-B-5380890
Patent Literature 2: JP-A-H11-290951
Patent Literature 3: JP-A-2008-105088
Patent Literature 4: JP-A-2017-154160

### Summary of Invention

### Technical Problem

Patent Literature 1 proposes a method in which an emboss is formed on a stretch flange portion and an excess bead is formed on a shrink flange portion to make a residual stress uniform for reduction of the springback. However, in a press-formed product having a low-rigidity shape to which the present invention is mainly directed, the springback is generated even by a low stress, and therefore, even a reduction in stress of a specific portion may be insufficient. In addition, in a state where a new stress is generated as a result of the reduction in stress of a specific portion, springback in another form can occur. Therefore, with a press-formed product having a low-rigidity shape, it is difficult to efficiently take a countermeasure for springback through stress control.

Patent Literature 2 proposes a press-forming method in which, in press-forming a flanged channel-shaped member using a high strength steel sheet, a flange portion is provided with a bead so that tension applied to a vertical wall portion during press-forming is increased to improve the dimension accuracy. In addition, Patent Literature 3 proposes a technique of preventing generation of warpage by providing a bead at a bottom portion of a square-shaped drawn container along a fillet portion of the long side. These techniques are effective when it is preliminarily known technically or empirically as to on which portion the bead should be set. However, a press-formed product having a low rigidity shape to which the present invention is mainly directed originally has a low rigidity, and the springback can be generated even by a low stress. Thus, the starting position or direction of the springback can easily change. Therefore, the position or direction of the bead, the number of beads to be set, and the like optimal for suppressing the springback are not necessarily constant.

Patent Literature 4 proposes a technique of suppressing warpage due to a bending moment by providing beads on non-pierced portions located between pierced portions that are circumferentially adjacent to each other in a damper plate material, in which it is desirable to provide the beads in a direction of crossing, particularly a direction perpendicular to a straight line connecting a pair of mutually adjacent pierced portions. However, a press-formed product does not necessarily have a symmetrical shape, and therefore the bead setting location is not always determined uniquely depending on the shape of a part.

Specifically, the problems of the conventional techniques to be solved are listed below.
(1) To set a part with low rigidity to have a press-formed product shape effective for suppressing the springback.
(2) To determine an optimal arrangement of a rigidity adding shape effective for reducing the springback of a press-formed product having a low rigidity shape.

The present invention has been made in view of the aforementioned problems inherent to the conventional techniques, and it is an object of the present invention to provide a rigidity improvement method that is effective for springback suppression measures by improving a rigidity of a press-formed product with a low rigidity shape, and can press-form a press-formed product having a small amount of springback after press-forming and an excellent shape fixability, a press-forming die using the method, a press-formed product, and a method for producing the press-formed product.

### Solution to Problem

A rigidity improvement method for a press-formed product of the present invention is characterized in that
in improving rigidity of a press-formed product produced by press-forming a sheet material by a rigidity adding shape to suppress springback at a time when the press-formed product is removed from a die,
the rigidity adding shape is arranged so as to extend in a direction of crossing a displacement contour indicating a state of springback in an initial shape prior to the arrangement of the rigidity adding shape of the press-formed product.

Further, a press-forming die of the present invention using the aforementioned rigidity improvement method is a press-forming die for producing a press-formed product on which a rigidity adding shape is arranged, from a sheet material to suppress springback at a time when the press-formed product is removed from a die, comprising:
a die member configured to form the rigidity adding shape so as to extend in a direction of crossing a displacement contour indicating a state of springback in an initial shape prior to the arrangement of the rigidity adding shape of the press-formed product.

Further, a press-formed product of the present invention using the aforementioned rigidity improvement method is a press-formed product produced by press-forming a sheet material and on which a rigidity adding shape is arranged, to suppress springback at a time of removal from a die, in which
the rigidity adding shape is arranged so as to extend in a direction of crossing a displacement contour indicating a state of springback in an initial shape prior to the arrangement of the rigidity adding shape of the press-formed product.

Further, a method for producing a press-formed product of the present invention is characterized in that
in producing a press-formed product on which a rigidity adding shape is arranged by press-forming a sheet material to suppress springback at a time of removal from a die,
the rigidity adding shape is arranged so as to extend in a direction of crossing a displacement contour indicating a state of springback in an initial shape prior to the arrangement of the rigidity adding shape of the press-formed product.

### Advantageous Effects of Invention

In the rigidity improvement method for a press-formed product of the present invention, in improving the rigidity of a press-formed product produced by press-forming a sheet material by a rigidity adding shape to suppress the springback at the time when the press-formed product is removed from a die, the rigidity adding shape is arranged so as to extend in a direction of crossing a displacement contour indicating a state of springback in an initial shape prior to the arrangement of the rigidity adding shape of the press-formed product. Therefore, falling or rising of an end of the press-formed product or twisting of the press-formed product that occurs when the press-formed product is bent along the direction of crossing the displacement contour at a removal from the die can be effectively suppressed by the rigidity adding shape, and the springback of the press-formed product having a low rigidity shape can be effectively suppressed.

In addition, with the press-forming die of the present invention, the die member of the press-forming die forms the rigidity adding shape on the press-formed product so as to extend in a direction of crossing the displacement contour indicating a state of springback in an initial shape prior to the arrangement of the rigidity adding shape of the press-formed product. Therefore, falling or rising of an end of the press-formed product or twisting of the press-formed product that occurs when the press-formed product is bent along the direction of crossing the displacement contour at a removal from the die can be effectively suppressed by the rigidity adding shape, and the springback of the press-formed product having a low rigidity shape can be effectively suppressed.

Further, with the press-formed product and by the method for producing the press-formed product of the present invention, in order to suppress springback at the time of removal from the die, the press-formed product is produced by press-forming a sheet material and the rigidity adding shape is arranged thereon so as to extend in the direction of crossing the displacement contour indicating a state of springback in an initial shape prior to the arrangement of the rigidity adding shape of the press-formed product. Therefore, falling or rising of an end of the press-formed product or twisting of the press-formed product that occurs when the press-formed product is bent along the direction of crossing the displacement contour at a removal from the die can be effectively suppressed by the rigidity adding shape, and the springback of the press-formed product having a low rigidity shape can be effectively suppressed.

Note that, by the rigidity improvement method for a press-formed product, the press-forming die, the press-formed product, and the method for producing the press-formed product of the present invention, the displacement contour may be obtained by a springback analysis of the initial shape, and the rigidity adding shape may be arranged so as to extend in the direction of crossing the displacement contour. Thus, the rigidity adding shape can be appropriately arranged at a position inside the initial shape where the direction of crossing the displacement contour is unclear.

In the aforementioned case, a plurality of rigidity adding shapes may be arranged so as to extend in the direction of crossing the displacement contour, and adjacent rigidity adding shapes of the plurality of rigidity adding shapes may be overlapped with each other and extended in the direction of crossing the displacement contour. Thus, no gap is formed in the extending direction thereof between the plurality of rigidity adding shapes extending in the direction of crossing the displacement contour, and the press-formed product can be prevented from bending along the direction of crossing the displacement contour at the gap portion, so that the springback of the press-formed product can be suppressed effectively.

In addition, by the rigidity improvement method for a press-formed product, the press-forming die, the press-formed product, and the method for producing the press-formed product of the present invention, the rigidity adding shape may have a closed profile shape arranged so as to extend along a peripheral edge of the initial shape. Thus, since the displacement contour usually extends in the direction of crossing the peripheral edge of the initial shape, even if the displacement contour is not obtained by a springback analysis, the rigidity adding shape can be arranged so as to extend in the direction of crossing the displacement contour, and therefore the springback of the press-formed product can be suppressed easily.

### Brief Description of Drawings

FIG. 1 is a perspective view illustrating an initial shape of a press-formed product according to an embodiment of the present invention whose rigidity is to be improved by a rigidity improvement method for a press-formed product according to an embodiment of the present invention.
FIG. 2 is a plan view illustrating a height directional displacement distribution by a springback analysis of the press-formed product having the initial shape by displacement contour.
FIG. 3 is an explanatory view illustrating three rigidity adding shapes arranged by the rigidity improvement method of the aforementioned embodiment on the press-formed product having the initial shape together with the displacement contour of FIG. 2.
FIG. 4 is a plan view illustrating a height directional displacement distribution by a springback analysis of a press-formed product of an embodiment of the present invention on which the three rigidity adding shapes are arranged by displacement contour.
FIG. 5 is an explanatory view illustrating a rigidity adding shape arranged by the rigidity improvement method of another embodiment of the present invention on the press-formed product having the initial shape together with the displacement contour of FIG. 2.

### Description of Embodiments

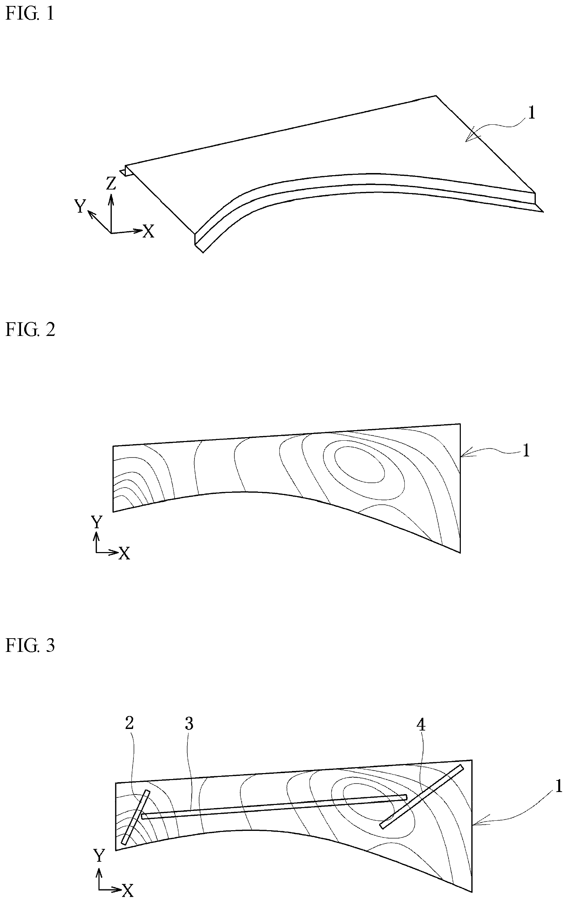

Embodiments of the present invention will be described in detail below on the basis of the drawings. Here, FIG. 1 is a perspective view illustrating an initial shape of a press-formed product according to an embodiment of the present invention whose rigidity is to be improved by a rigidity improvement method for a press-formed product according to an embodiment of the present invention. FIG. 2 is a plan view illustrating a height directional displacement distribution by a springback analysis of the press-formed product having the initial shape by displacement contour. FIG. 3 is an explanatory view illustrating three rigidity adding shapes arranged by the rigidity improvement method of the aforementioned embodiment on the press-formed product having the initial shape together with the displacement contour of FIG. 2. In the drawings, reference numeral 1 denotes a press-formed product.

The rigidity improvement method for a press-formed product according to the aforementioned embodiment is to improve the rigidity of the press-formed product 1, which is a front pillar lower inner material as a type of a body part of an automobile, and the press-formed product 1 usually has a trapezoidal shape which is usually easy to bend and twist, i.e., a shape with a low rigidity. Note that a press-formed product, which is an automobile body part, often has such a low rigidity shape. The initial shape of the press-formed product 1 illustrated in FIG. 1 is subjected to a press formation analysis and a springback analysis with a computer using known software, resulting that, as illustrated in FIG. 2, it can be seen that the interval of the displacement contours is relatively narrow in a longitudinal direction (X-axis direction) and the displacement contours are asymmetrically distributed in a width direction (Y-axis direction), and falling and twisting occur due to the springback.

Thus, in the rigidity improvement method for a press-formed product of the present embodiment, the press-formed product 1 includes three rod-shaped beads 2, 3, 4, which are each a rigidity adding shape, as illustrated in FIG. 3, and the three rod-shaped beads 2, 3, 4 add rigidity to the initial shape of the press-formed product 1. Note that the cross-sectional shape of each of the three rod-shaped beads 2, 3, 4 may be, for example, a smooth sine wave shape for easy formation, may be a rectangular wave shape for further increased rigidity, or may vary between the rod-shaped beads 2, 3, 4.

In the rigidity improvement method for a press-formed product of the present embodiment, the three rod-shaped beads 2, 3, 4 are each arranged so as to extend in a direction of crossing the displacement contours of the initial shape of the press-formed product 1, and adjacent rod-shaped beads 2, 3 and adjacent rod-shaped beads 3, 4 are arranged so as to be overlapped with each other and extended in a direction of crossing the displacement contours, thereby to constitute the press-formed product of the aforementioned embodiment.

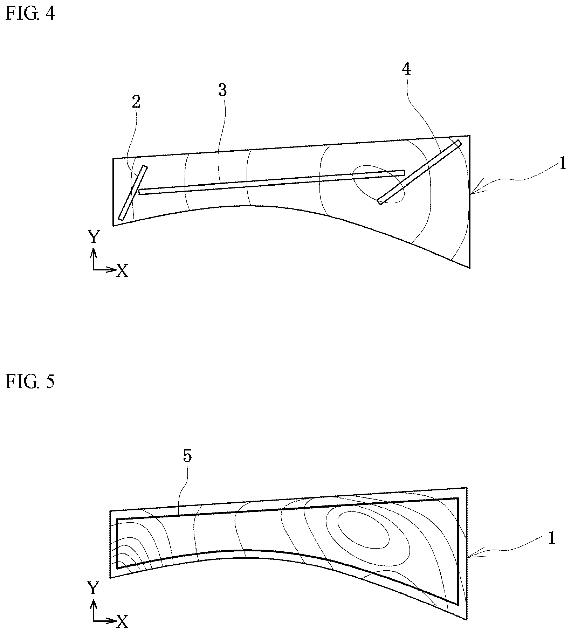

As is the case for the initial shape, the shape of the press-formed product 1 of the embodiment in which the rod-shaped beads 2, 3, 4 are arranged as described above is subjected to a press formation analysis and a springback analysis with a computer using known software. As illustrated in FIG. 4, the interval of the displacement contours is relatively wide in the longitudinal direction (X-axis direction), and the displacement contours are symmetrically distributed in the width direction (Y-axis direction), and it can be seen that falling and twisting due to the springback are reduced or eliminated.

A sheet material forming the press-formed product 1 of the present embodiment can be, for example, a 980 MPa-class high-tensile steel sheet having a thickness t: 0.9 mm, a yield point YP: 620 MPa, a tensile strength TS: 1030 MPa, and an elongation El: 15%. The method for producing a press-formed product of an embodiment of the present invention uses a press-forming die of an embodiment of the present invention to press-form the high-tensile steel sheet so as to form the press-formed product 1 of the aforementioned embodiment.

Therefore, the press-forming die of the aforementioned embodiment includes, as a die member, a normal punch, die and blank holder. The die has a thin trapezoidal shape above outward flanges positioned at upper and lower ends of the press-formed product 1 in FIG. 1 and a concave portion having a shape that corresponds to the rod-shaped beads 2, 3, 4 of FIG. 3 protruding upward from a planar surface of the trapezoidal shape. The blank holder holds a steel sheet between the blank holder and a plane surface extending outward from the concave portion of the die. The punch pushes the steel sheet, which is held between the die and the blank holder, into the concave of the die to form the steel sheet into a thin trapezoidal shape, and pushes a convex portion of the leading end of the punch into the concave portion of the die so as to form the rod-shaped beads 2, 3, 4 by extrusion on the planar surface of the trapezoidal shape.

Here, the concave portion of the die and the concave portion of the leading end of the punch of the press-forming die of the aforementioned embodiment are formed such that each of the rod-shaped beads 2, 3, 4 extends in a direction of crossing the displacement contour of the initial shape of the press-formed product 1 and adjacent rod-shaped beads 2, 3 and adjacent rod-shaped beads 3, 4 are overlapped with each other and extended in the direction of crossing the displacement contours.

By the method for producing the press-formed product of the aforementioned embodiment, on the press-formed product 1 formed using the press-forming die of the aforementioned embodiment, the rod-shaped beads 2, 3, 4 arranged thereon extend in the direction of crossing the displacement contour indicating a state of springback in the initial shape of the press-formed product 1, and thus the press-formed product 1 is the press-formed product of the aforementioned embodiment. With the press-formed product of the present embodiment and by the method for producing the press-formed product, falling or rising of an end of the press-formed product 1 or twisting of the press-formed product 1 that occurs when the press-formed product 1 is bent along the direction of crossing the displacement contour at a removal from the die can be effectively suppressed by the rod-shaped beads 2, 3, 4, and the springback of the press-formed product 1 can be effectively suppressed.

Moreover, with the press-formed product of the present embodiment and by the method for producing the press-formed product, the adjacent rod-shaped beads 2, 3 and the adjacent rod-shaped beads 3, 4 are overlapped with each other and extended in the direction of crossing the displacement contour. Therefore, no gap is formed in the extending direction thereof between the three rod-shaped beads 2, 3, 4 extending in the direction of crossing the displacement contour, and the press-formed product 1 can be prevented from bending along the direction of crossing the displacement contour at the gap portion, so that the springback of the press-formed product 1 can be suppressed effectively.

FIG. 5 is an explanatory view illustrating a rigidity adding shape arranged by a rigidity improvement method of another embodiment of the present invention on the press-formed product having the initial shape together with the displacement contour of FIG. 2. In the rigidity improvement method for a press-formed product of the present embodiment, a frame-shaped bead 5 obtained by connecting rod-shaped beads in a frame shape is arranged as a rigidity adding shape on the initial shape of the press-formed product 1 illustrated in FIG. 1. The frame-shaped bead 5 has a closed profile shape arranged to protrude upward so as to extend along a peripheral edge near the peripheral edge of the trapezoidal shape of the initial shape of the press-formed product 1 illustrated in FIG. 1.

The displacement contours usually extend in the direction of crossing the peripheral edge near the peripheral edge of the initial shape. Therefore, by the rigidity improvement method for a press-formed product of the present embodiment, the press-formed product of another embodiment of the present invention whose rigidity is improved by the rigidity improvement method, and the method for producing a press-formed product of another embodiment of the present invention that press-forms the press-formed product, even if the displacement contours are not obtained by a springback analysis, the frame-shaped bead 5 can be arranged so as to extend in the direction of crossing the displacement contour, whereby the springback of the press-formed product 1 can be suppressed easily.

Further, the press-forming die that produces the press-formed product of the present embodiment whose rigidity is improved by the rigidity improvement method of the present embodiment can also be configured as the press-forming die of the previous embodiment, and the same effect as that obtained by the press-forming die of the previous embodiment can be provided.

The embodiments have been described heretofore. However, the rigidity improvement method for a press-formed product, the press-forming die, the press-formed product, and the method for producing the press-formed product of the present invention are not limited to the aforementioned embodiments, but can be properly changed within the scope of the claims. For example, the shape of the press-formed product or the rigidity adding shape may be a downwardly recessed bead shape, instead of or in addition to the upwardly protruding bead shape, and the frame-shaped bead 5 illustrated in FIG. 5 may have a step shape that is one step higher or lower within the frame instead of the rod-shaped bead shape.

### Industrial Applicability

Thus, by the rigidity improvement method for a press-formed product, the press-forming die, the press-formed product, and the method for producing the press-formed product of the present invention, the springback of the press-formed product having a low rigidity shape can be suppressed effectively.

### Reference Signs List

- 1: press-formed product
- 2, 3, 4: rod-shaped bead (rigidity adding shape)
- 5: frame-shaped bead (rigidity adding shape)

## Claims

1. A rigidity improvement method for a press-formed product,
**characterized in that**
in improving rigidity of a press-formed product produced by press-forming a sheet material by a rigidity adding shape, to suppress springback at a time when the press-formed product is removed from a die,
the rigidity adding shape is arranged so as to extend in a direction of crossing a displacement contour indicating a state of springback in an initial shape prior to an arrangement of the rigidity adding shape of the press-formed product.

2. The rigidity improvement method for a press-formed product according to claim 1, wherein
the displacement contour is obtained by a springback analysis of the initial shape, and the rigidity adding shape is arranged so as to extend in the direction of crossing the displacement contour.

3. The rigidity improvement method for a press-formed product according to claim 2, wherein
a plurality of rigidity adding shapes are arranged so as to extend in the direction of crossing the displacement contour, and
adjacent rigidity adding shapes of the plurality of rigidity adding shapes are overlapped with each other and extended in the direction of crossing the displacement contour.

4. The rigidity improvement method for a press-formed product according to claim 1, wherein
the rigidity adding shape has a closed profile shape arranged so as to extend along a peripheral edge of the initial shape.

5. A press-forming die for producing a press-formed product on which a rigidity adding shape is arranged from a sheet material to suppress springback at a time when the press-formed product is removed from a die,
**characterized in that**
the press-forming die comprises a die member configured to form the rigidity adding shape so as to extend in a direction of crossing a displacement contour indicating a state of springback in an initial shape prior to an arrangement of the rigidity adding shape of the press-formed product.

6. The press-forming die according to claim 5, wherein
the displacement contour is obtained by a springback analysis of the initial shape, and the rigidity adding shape is arranged so as to extend in the direction of crossing the displacement contour.

7. The press-forming die according to claim 6, wherein
a plurality of rigidity adding shapes are arranged so as to extend in the direction of crossing the displacement contour, and
adjacent rigidity adding shapes of the plurality of rigidity adding shapes are overlapped with each other and extended in the direction of crossing the displacement contour.

8. The press-forming die according to claim 5, wherein
the rigidity adding shape has a closed profile shape arranged so as to extend along a peripheral edge of the initial shape.

9. A press-formed product produced by press-forming a sheet material and on which a rigidity adding shape is arranged to suppress springback at a time when the press-formed product is removed from a die,
**characterized in that**
the rigidity adding shape is arranged so as to extend in a direction of crossing a displacement contour indicating a state of springback in an initial shape prior to an arrangement of the rigidity adding shape of the press-formed product.

10. The press-formed product according to claim 9, wherein
the displacement contour is obtained by a springback analysis of the initial shape, and the rigidity adding shape is arranged so as to extend in a direction of crossing the displacement contour.

11. The press-formed product according to claim 10, wherein
a plurality of rigidity adding shapes are arranged so as to extend in the direction of crossing the displacement contour, and
adjacent rigidity adding shapes of the plurality of rigidity adding shapes are overlapped with each other and extended in the direction of crossing the displacement contour.

12. The press-formed product according to claim 9, wherein
the rigidity adding shape has a closed profile shape arranged so as to extend along a peripheral edge of the initial shape.

13. A method for producing a press-formed product,
**characterized in that**
in producing a press-formed product on which a rigidity adding shape is arranged by press-forming a sheet material, to suppress springback at a time of removal from a die,
the rigidity adding shape is arranged so as to extend in a direction of crossing a displacement contour indicating a state of springback in an initial shape prior to an arrangement of the rigidity adding shape of the press-formed product.

14. The method for producing a press-formed product according to claim 13, wherein
the displacement contour is obtained by a springback analysis of the initial shape, and
the rigidity adding shape is arranged so as to extend in a direction of crossing the displacement contour.

15. The method for producing a press-formed product according to claim 14, wherein
a plurality of rigidity adding shapes are arranged so as to extend in the direction of crossing the displacement contour, and
adjacent rigidity adding shapes of the plurality of rigidity adding shapes are overlapped with each other and extended in the direction of crossing the displacement contour.

16. The method for producing a press-formed product according to claim 13, wherein
the rigidity adding shape has a closed profile shape arranged so as to extend along a peripheral edge of the initial shape.
